# EUROPEAN PATENT SPECIFICATION

(11) **EP 1 508 003 B1**
(45) Date of publication and mention of the grant of the patent: **29.11.2006**
(21) Application number: 03722466.4
(22) Date of filing: 14.04.2003
(51) Int. Cl.: F24H 9/20

(54) **CONTROL ARRANGEMENT FOR HEATING DEVICES**
STEUERANORDNUNG FÜR HEIZVORRICHTUNGEN
DISPOSITIF DE COMMANDE POUR APPAREILS DE CHAUFFAGE

(30) Priority: 24.05.2002 IT PN20020029
(43) Date of publication of application: 23.02.2005
(73) Proprietor: IRCA S.p.A., I-31020 S. Vendemiano, Treviso (IT)
(72) Inventor: TAURIAN, Andrea, I-33072 Casarsa della Delizia, Pordenone (IT); MARCHETTI, Corrado, I-31052 Varago, Treviso (IT); POSER, Ivan, I-31014 Colle Umberto, Treviso (IT)
(74) Representative: Giugni, Valter
(86) International application number: PCT/EP2003/003848
(87) International publication number: WO 2003/100326

(56) References cited:
- EP-B- 0 080 428
- GB-A- 2 211 593

## Description

The present invention relates to a control arrangement for electric heating devices, in particular heating elements of the type associated to radiators, or the like, provided with a system for cooling-down the same control arrangement.

An example of such a control arrangement is given in EP-B-0 080 428.

Electrically energized heating radiators are generally known to mainly comprise a radiant body which contains a mass of oil that is in a heat-exchange contact with an electric heating element arranged at the base of the radiator. The power supply to this electric heating element is controlled thermostatically through an electronic circuitry that comprises at least an element, usually consisting of a Triac, for controlling the power output.

The whole set of electronic circuits, along with the related adjustment and control means, is collected in a box-like protection casing that, owing to reasons that are not only aesthetical, but also practical, i.e. aimed at reducing encumbrance, is arranged adjacent to the electric heating element or the radiant body itself, i.e. in a position in which the entire control device is exposed to heat and, therefore, is substantially heated up.

As a matter of fact, the above cited element for controlling the power output would rather require being adequately cooled down, owing to the fact that, during operation, it actually tends to overheat and such an overheating tends in turn to drastically reduce the average life thereof.

In addition, a further drawback that is experienced with the above mentioned control arrangements lies in the fact that these arrangements are usually unprotected against liquids or, more in general, foreign matters dripping or falling upon them and possibly contaminating or damaging them.

It therefore is a purpose of the present invention to provide a control arrangement for electric heating devices and apparatuses that is provided with a simple and effective cooling system which enables the above mentioned drawbacks connected with this kind of control arrangements, and in particular the power electronic component parts thereof, to be done away with or at least substantially minimized.

According to the present invention, this aim is reached in a control arrangement for electric heating devices with cool-down system incorporating the characteristics as recited in the appended claims.

Anyway, features and advantages of the present invention can be more readily understood from the description that is given below by mere way of non-limiting example with reference to the accompanying drawings, in which:
- Figure 1 is a schematic, partially cross-sectional front view of a radiator associated to a control arrangement according to the present invention;
- Figure 2 is a schematic, cross-sectional, enlarged-scale side view of the control arrangement according to a preferred embodiment; and
- Figure 3 is a cross-sectional view of the control arrangement along the A-A' line of Figure 2.

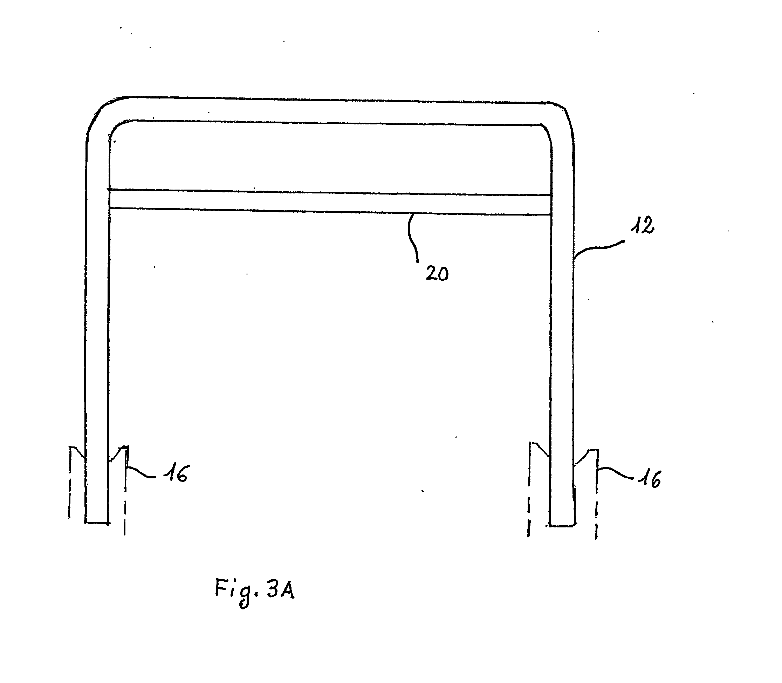

With reference to the Figures, the control arrangement according to the present invention mainly comprises a circuitry (generally indicated at 1 in Figure 3) that is adapted to drive, i.e. control an electric heating element 3 through at least an element 2, which preferably comprises a Triac, for controlling the power output thereof.

The electric heating element 3, to which power can be supplied via a cable 7, is preferably of the cartridge-type, adapted to be inserted in a tightly sealing manner in a radiant apparatus 4 which may be of the type containing a mass of oil, or the like, adapted to be heated up by the electric heating element itself.

An end portion 5 of said electric heating element 3 is connected to a box-like casing 6, which accommodates the power-control element 2 and the related control circuitry 1 in the manner that shall be more closely described further on.

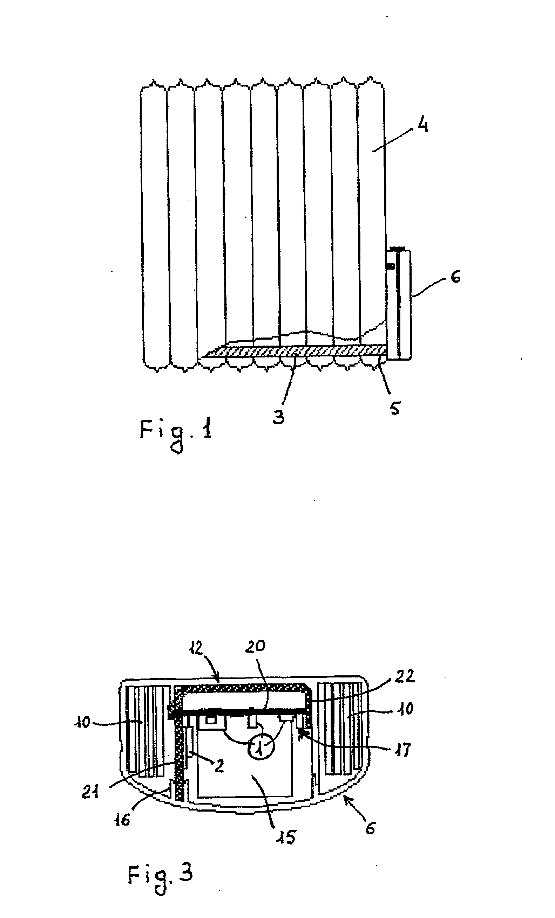

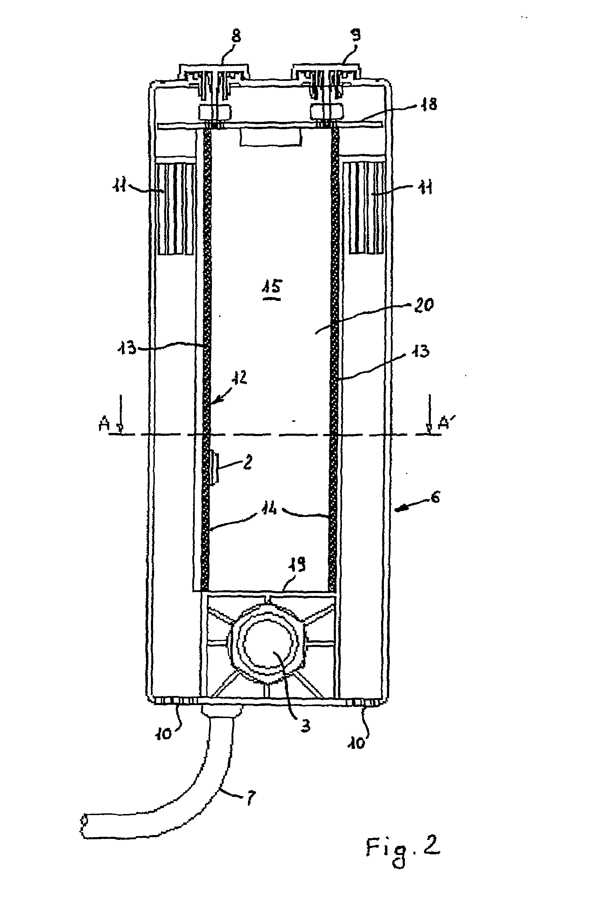

As this is best shown in Figures 1 and 2, the box-like casing 6 is adapted to be installed in a laterally juxtaposed position with respect to the radiator 4, wherein the electric heating element 3 is electrically connected to the circuitry 1 via the Triac 2.

In a basically per se known manner, said circuitry 1 is also connected to adjustment or regulation members 8, 9 that are provided for access on the outside of the casing 6 and are adapted to selectively set the temperature and/or the mode of operation of the whole heating apparatus 3-6.

According to a first feature of the present invention, the casing 6 comprises apertures 10, 11 adapted to enable at least a flow of ambient air to circulate inside the same casing so as to cool down the power control element 2.

In view of an increased effectiveness, the apertures 10, 11 are preferably provided in correspondence of the bottom portion and the top portion, respectively, of the casing 6, in such a manner as to favour the natural circulation of the above cited flow of cooling air due to "stack effect". It will of course be appreciated that the flow of cooling air may also be a forced one, i.e. be brought about by forced convection.

In any case, according to a further feature of the present invention, the power control element 2, usually a Triac, is applied on to a heat-conducting wall 12 arranged vertically in the flow-path of said cooling air, in such a manner as to actually form a cooling radiator for said Triac.

The heat-conducting wall 12, which is preferably of metal and may be shaped so as to feature a substantially J-contoured or U-contoured cross-section (Figure 3), extends substantially vertically into the casing 6 with a large outer surface 13 and a large inner surface 14 that favour the heat-sinking effect, i.e. heat dissipation from the Triac 2, the latter being of course applied in contact with said surface according to any of a number of generally known methods.

In the course of exhaustive experiments that have been carried out in this connection, it has been found that an optimum cooling effect is obtained both as far as said Triac and said electronic circuits 1 arranged on an appropriate board are concerned, when said heat-conducting wall 12 is U-shaped, or J-shaped, and extends vertically into the casing 6, as this is shown in Figure 3 or, symbolically, in Figure 3A.

In the above described configuration, the heat-conducting wall 12 is mechanically coupled to the inner surface of the casing 6 so as to form a substantially isolated inner space 15 in which there are accommodated the power control element 2 and at least part of the related control circuitry 1. Such a mechanical coupling can be easily made in correspondence of the peripheral borders of the wall 12, which are adapted to engage respective connection members provided inside the casing 6 and are indicated at 16, 17 and 19, respectively, in the example illustrated in the Figures. In particular, in order to prevent the heat from the electric heating element 3 from being transmitted to the electronic circuitry arranged thereabove, there is most advantageously provided a suitable, preferably insulating lower wall 19 which separates said inner space 15 from the electric heating element 3 located therebelow.

The control circuitry 1 is preferably formed by component parts that are mounted on at least a printed-circuit board 20, which can in turn be advantageously mounted across the inner space 15 so as to extend between opposite portions 21, 22 of the heat-conducting wall 12. It will of course be appreciated that said component parts of the circuitry 1 can be mounted indifferently on either side of said board 20.

It has been however observed that the best cooling effect is obtained when the Triac and the other components of the board 20 come to lie inside the inner space 15, since the heat emitted by them is transferred onto and is dissipated by irradiation over the whole or the largest part of the inner surface of the heat-conducting wall 12.

In any case, through the wall 12 acting as a heat-sink, the power control element 2 is advantageously and effectively cooled down by the flow of air circulating in the casing 6 through the apertures 10, 11, so that the entire control arrangement turns out to be most reliable and constant in its operation.

In addition, the substantially enclosed form of the wall 12 enables a kind of cell to be created, in which substantially the power control element 2 and the related control circuitry 1 are isolated from the outside ambient, thereby limiting the risk of possible accidental moisture or water seepages through the apertures 10, 11 being able to give rise to short-circuit conditions and/or oxidizing events of electric live parts.

## Claims

1. Control arrangement for at least an electric heating device, comprising a box-like casing (6) that accommodates a circuitry adapted to drive said electric heating device via at least a power control element (2), said box-like casing (6) comprising apertures (10, 11) enabling at least a flow of ambient air to circulate inside the same casing for cooling down said power control element (2), **characterized in that** a heat-conducting wall (12) is mechanically coupled to the inner surface of said box-like casing (6) in such a manner as to form a substantially isolated inner space (15), in which there are enclosed said power control element (2) and at least part of the related control circuitry (1).

2. Control arrangement according to claim 1, **characterized in that** said flow of cooling air is brought about by said apertures (10, 11) by natural circulation due to stack effect.

3. Control arrangement according to claim 2, **characterized in that** said power control element (2) is in contact with said heat-conducting wall (12).

4. Control arrangement according to any of the preceding claims, **characterized in that** said heat-conducting wall has a cross-section in the shape of a U or a J.

5. Control arrangement according to any of the preceding claims, **characterized in that** said control circuitry (1) comprises components that are mounted on at least a printed-circuit board (20), which is in turn mounted across said inner space (15) and extends between opposite portions (21, 22) of said heat-conducting wall (12).

## Patentansprüche

1. Steueranordnung für mindestens eine elektrische Heizvorrichtung, die ein kastenähnliches Gehäuse (6) aufweist, das eine Schaltung aufnimmt, die so aufgebaut ist, um die elektrische Heizvorrichtung über mindestens ein Leistungssteuerelement (2) anzusteuern, wobei das kastenähnliche Gehäuse (6) Öffnungen (10, 11) aufweist, die ermöglichen, dass zumindest eine Strömung aus Umgebungsluft innerhalb dieses Gehäuses zirkuliert, um das Leistungssteuerelement (2) abzukühlen, **dadurch gekennzeichnet, dass** eine wärmeleitende Wand (12) mechanisch mit der inneren Oberfläche des kastenähnlichen Gehäuses (6) in einer solchen Art und Weise verbunden ist, um einen im Wesentlichen isolierten Innenraum (15) zu bilden, in dem das Leistungssteuerelement (2) und zumindest ein Teil der entsprechenden Steuerschaltung (1) umschlossen sind.

2. Steueranordnung nach Anspruch 1, **dadurch gekennzeichnet, dass** die Strömung der Kühlluft durch die Öffnungen (10, 11) über eine natürliche Zirkulation aufgrund eines Stapeleffekts ("Stack-Effekt") erzielt wird.

3. Steueranordnung nach Anspruch 2, **dadurch gekennzeichnet, dass** das Leistungssteuerelement (2) in Kontakt mit der wärmeleitenden Wand (12) steht.

4. Steueranordnung nach einem der vorhergehenden Ansprüche, **dadurch gekennzeichnet, dass** die wärmeleitende Wand einen Querschnitt in der Form eines U oder eines J besitzt.

5. Steueranordnung nach einem der vorhergehenden Ansprüche, **dadurch gekennzeichnet, dass** die Steuerschaltung (1) Bauteile aufweist, die auf mindestens einer Leiterplatte (20) montiert sind, die wiederum quer über den Innenraum (15) montiert ist und sich zwischen gegenüberliegenden Bereichen (21, 22) der wärmeleitenden Wand (12) erstreckt.

## Revendications

1. Dispositif de commande pour au moins un appareil de chauffage électrique, comprenant un carter du type boîte (6) qui loge un circuit adapté pour commander ledit appareil de chauffage électrique via au moins un élément de commande de puissance (2), ledit carter du type boîte (6) comprenant des ouvertures (10, 11) permettant à au moins un flux d'air ambiant de circuler à l'intérieur du même carter pour refroidir ledit élément de commande de puissance (2), **caractérisé en ce qu'**une paroi conductrice de chaleur (12) est couplée mécaniquement à la surface intérieure dudit carter du type boîte (6) de telle manière à former un espace intérieur sensiblement isolé (15), dans lequel est inclus ledit élément de commande de puissance (2), et au moins une partie du circuit de commande associé (1).

2. Dispositif de commande selon la revendication 1, **caractérisé en ce que** ledit flux d'air refroidissant est amené par lesdites ouvertures (10, 11) par la circulation naturelle due à l'appel d'air.

3. Dispositif de contrôle selon la revendication 2, **caractérisé en ce que** ledit élément de commande de puissance (2) est en contact avec ladite paroi conductrice de chaleur (12).

4. Dispositif de commande selon l'une quelconque des revendications précédentes, **caractérisé en ce que** ladite paroi conductrice de chaleur a une section en coupe ayant la forme d'un U ou d'un J.

5. Dispositif de commande selon l'une quelconque des revendications précédentes, **caractérisé en ce que** ledit circuit de commande (1) comprend des composants qui sont montés sur au moins une carte de circuit imprimée (20), qui est à son tour montée en travers dudit espace intérieur (15) et s'étend entre des portions opposées (21, 22) de ladite paroi conductrice de chaleur (12).
